(19) Europäisches Patentamt
European Patent Office
Office européen des brevets

(11) **EP 4 607 589 A1**

(12) **EUROPEAN PATENT APPLICATION**

(43) Date of publication:
**27.08.2025 Bulletin 2025/35**

(21) Application number: **24158949.8**

(22) Date of filing: **21.02.2024**

(51) International Patent Classification (IPC):
**H01L 23/495** (2006.01)

(52) Cooperative Patent Classification (CPC):
**H01L 23/49562; H01L 23/49541; H01L 23/49568;
H01L 23/49575;** H01L 23/49551

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Infineon Technologies Austria AG
9500 Villach (AT)**

(72) Inventor: **YUFEREV, Sergey
9500 Villach (AT)**

(74) Representative: **Lambsdorff & Lange
Patentanwälte
Partnerschaft mbB
Grillparzerstraße 12A
81675 München (DE)**

(54) **VERTICAL GAN DEVICE**

(57) A chip package includes a GaN chip having a first side and a second side opposite the first side. The first side comprises chip pads. The chip package further includes a leadframe having a first main side and a second main side opposite the first main side. The first main side of the leadframe faces the first side of the GaN chip and is attached to the chip pads. The leadframe is configured to be attached to an application board in inclined, in particular vertical orientation relative to the application board.

**Fig. 11A**

Processed by Luminess, 75001 PARIS (FR)

EP 4 607 589 A1

## Description

### Technical Field

This disclosure relates generally to the technique of semiconductor packaging, and in particular to a GaN chip leadframe package.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board as well as low assembly cost. Moreover, in particular for power applications, the packaging concept should provide for miniaturization (reduction of the footprint area), electrical efficiency and low $R_{DS(on)}$ (reduction of conduction losses and other losses), thermal efficiency, reduction of package parasitics, electromagnetic interference (EMI) safety (i.e., low radiated emissions), for example.

Chips based on GaN and silicon have principal differences. Special package concepts are needed for GaN chips, e.g. GaN transistor chips. Some package concepts rely on laminate-based package solutions. By doing so, the footprint design of the device is no longer limited by the pad layout of the chip. However, the usage of laminate in packaging leads to higher package cost and limitations in terms of solder materials which can be used. Further, due to the relatively low metal thickness of the redistribution layer in the laminate, low package resistances are difficult to obtain. Therefore, GaN chip packaging concepts employing leadframe (LF) technology have been proposed to overcome some of the above drawbacks.

### Summary

According to an aspect of the disclosure, a chip package includes a GaN chip having a first side and a second side opposite the first side. The first side comprises chip pads. The chip package further includes a leadframe having a first main side and a second main side opposite the first main side. The first main side of the leadframe faces the first side of the GaN chip and is attached to the chip pads. The leadframe is configured to be attached to an application board in inclined, in particular vertical orientation relative to the application board.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.

Figure 1A is a perspective bottom view of an example of a GaN chip package without mold compound.

Figure 1B is a perspective top view of the GaN chip package of Figure 1A with mold compound.

Figure 2 is a bottom view (footprint) of a GaN chip package similar to the GaN chip package of Figures 1A and 1B if designed as a horizontal package.

Figure 3A is a side perspective view illustrating the GaN chip package of Figures 1A and 1B without mold compound designed as a vertical package (i.e., the leadframe is configured to be attached to an application board in vertical orientation relative to the application board).

Figure 3B is a side view illustrating the GaN chip package of Figure 3A attached to an application board in vertical orientation relative to the application board.

Figure 4A illustrates current flow in a GaN chip package if designed as a horizontal package (compare Figures 1B and 2).

Figure 4B illustrates current flow in a GaN chip package configured as a vertical package in accordance with the disclosure.

Figure 5A is a side perspective view of a first example of a GaN chip package.

Figure 5B is a plan view from direction V1 (see Figure 5A) on the first example of a GaN chip package in transparent contour illustration.

Figure 5C is a side view from direction V2 (see Figure 5A) on the first example of a GaN chip package.

Figure 5D is a bottom view (footprint) from direction V3 (see Figure 5A) on the first example of a GaN chip package.

Figure 6A is a side perspective view of a second example of a GaN chip package.

Figure 6B is a plan view from direction V1 (see Figure 6A) on the second example of a GaN chip package in transparent contour illustration.

Figure 6C is a side view from direction V2 (see Figure 6A) on the second example of a GaN chip package.

Figure 6D is a bottom view (footprint) from direction V3 (see Figure 6A) on the second example of a GaN chip package.

Figure 7A is a side perspective view of a third example of a GaN chip package.

Figure 7B is a plan view from direction V1 (see Figure 7A) on the third example of a GaN chip package in transparent contour illustration.

Figure 7C is a side view from direction V2 (see Figure 7A) on the third example of a GaN chip package.

Figure 7D is a bottom view (footprint) from direction V3 (see Figure 7A) on the third example of a GaN chip package.

Figure 8A is a side perspective view of a fourth example of a GaN chip package.

Figure 8B is a plan view from direction V1 (see Figure 8A) on the fourth example of a GaN chip package in transparent contour illustration.

Figure 8C is a side view from direction V2 (see Figure 8A) on the fourth example of a GaN chip package.

Figure 8D is a bottom view (footprint) from direction V3 (see Figure 8A) on the fourth example of a GaN chip package.

Figure 9A is a perspective top view illustrating a GaN chip package having a top heat sink.

Figure 9B is a side view from direction V (see Figure 9A) on the GaN chip package having a top heat sink.

Figure 10 schematically illustrates combining two leadframes to form a dual-side GaN chip package.

Figure 11A is a side perspective view of a fifth example of a GaN chip package.

Figure 11B is a plan view from direction V (see Figure 11A) on the fifth example of a GaN chip package in transparent contour illustration.

Figure 12A is a side perspective view of a sixth example of a GaN chip package.

Figure 12B is a plan view from direction V (see Figure 12A) on the sixth example of a GaN chip package in transparent contour illustration.

Figure 12C illustrates current flow in the sixth example of a GaN chip package.

## Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" or similar terms with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" or similar terms used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

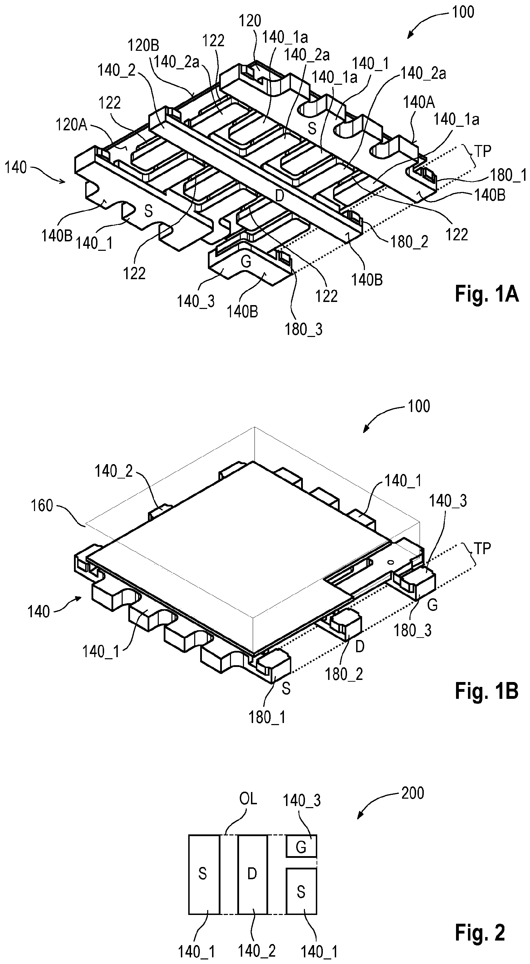

Referring to Figures 1A and 1B, a GaN chip package 100 includes a GaN chip 120. The GaN chip 120 has a first side 120A and a second side 120B opposite the first side 120A. Chip pads 122 are disposed at the first side 120A of the GaN chip 120. As known in the art, the chip pas 122 of the GaN chip 120 may be arranged in a comb-like design with interdigitated drain and source pads.

The GaN chip package 100 further includes a leadframe 140. The leadframe 140 has a first main side 140A and a second main side 140B opposite the first main side 140A. The first main side 140A of the leadframe 140 faces the first side 120A of the GaN chip 120 and is attached to the chip pads 122.

The leadframe 140 is configured to be attached to an application board in inclined, in particular vertical orientation relative to the application board. To that end, the leadframe 140 may include a terminal portion TP which is exposed and/or may protrude at one lateral side of the GaN chip package over the outline of the chip package given, e.g., by a mold compound 160 of the chip package 100. In Figure 1B the mold compound 160 is shown transparent for illustrative purposes. Further, only the active area AA of the GaN chip 120 is shown.

The leadframe 140 may include a plurality of segments. For example, the leadframe 140 may include at least one source (S) segment 140_1 and/or at least one drain (D) segment 140_2 and/or at least one gate (G) segment 140_3. In this case, at least one source terminal 180_1 of the chip package 100 may be formed by an end portion of the source segement(s) 140_1. At least one drain terminal 180_2 of the GaN chip package 100 may be formed by an end portion of the drain segment(s) 140_2. Further, at least one gate terminal 180_3 of the GaN chip package 100 may be formed by an end portion of the gate segment(s) 140_3.

For example, the source segment 140_1 is an elongated segment having laterally protruding source arms 140_1a. Similarly, the drain segment 140_2 may, e.g., be an elongated segment having laterally protruding drain arms 140_2a. The source arms 140_1a and the drain arms 140_2a may be interdigitated to align with the comb-like pattern of interdigitated drain and source pads on the GaN chip 120.

In the example shown, two source segments 140_1, one drain segment 140_2 and one gate segment 140_3 are provided. The drain segment 140_2 may, e.g., be disposed between a first source segment 140_1 (at the right side of Figure 1A) and a second source segment 140_1 (at the left side of Figure 1A). However, as will be described further below in more detail, a plurality of each type of segments 140_1, 140_2, 140_3 may, e.g., be provided.

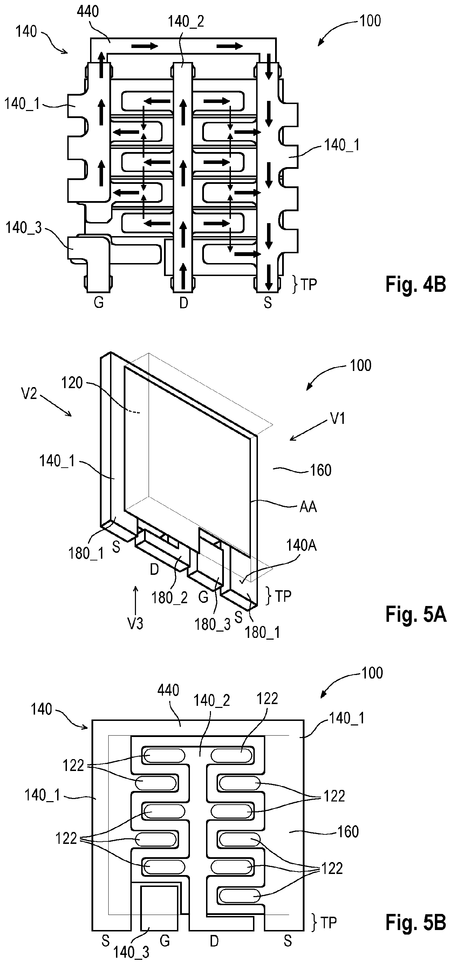

The source segment(s) 140_1, the drain segment(s) 140_2 and the gate segment(s) 140_3 are electrically disconnected with each other, i.e. are separate parts. If a plurality of segments of any of the above mentioned types (source segments 140_1, drain segments 140_2, gate segments 140_3) is provided, the segments of the same type may, e.g., be separate parts or integral parts. If they are separate parts, they may be electrically connected with each other through the GaN chip 120 (as illustrated in Figures 1A and 1B) or by a bridge segment (as will be described in conjunction with Figure 4B, for example). If they are integral parts, they are electrically connected with each other by the leadframe 140.

The end portions of the source segment(s) 140_1, the drain segment(s) 140_2 and the gate segment(s) 140_3 are part of the terminal portion TP of the leadframe 140. These end portions may form the source (S) terminal 180_1, the drain (D) terminal 180_2 and the gate (G) terminal 180_3, respectively.

If a plurality of source segments 140_1 and/or drain segments 140_2 and/or gate segments 140_3 are provided, it is possible that only one end portion of one of each of these segments may form the source terminal 180_1, the drain terminal 180_2 or the gate terminal 180_3, respectively. Alternatively, as will be described in more detail further below, it is also possible that a plurality of end portions of each type of these segments may form source terminals 180_1, drain terminals 180_2 or gate terminals 180_3, respectively.

Figure 2 illustrates a bottom view showing the footprint of a GaN chip package which is similar to the GaN chip package of Figures 1A and 1B if designed as a horizontal package. The footprint 200 is defined by the second main side 140B of the source, drain and gate segments 140_1, 140_2 and 140_3, respectively, of the leadframe 140. Apparently, if designed as a horizontal package, the leadframe 140 does not include a terminal portion TP at one lateral side of the GaN chip package 100.

For a horizontal package with a given GaN chip size, the footprint area A given by an outline OL surrounding the terminals of the GaN chip package 100 may be 3 mm $\times$ 3 mm = 9 mm$^2$, for example.

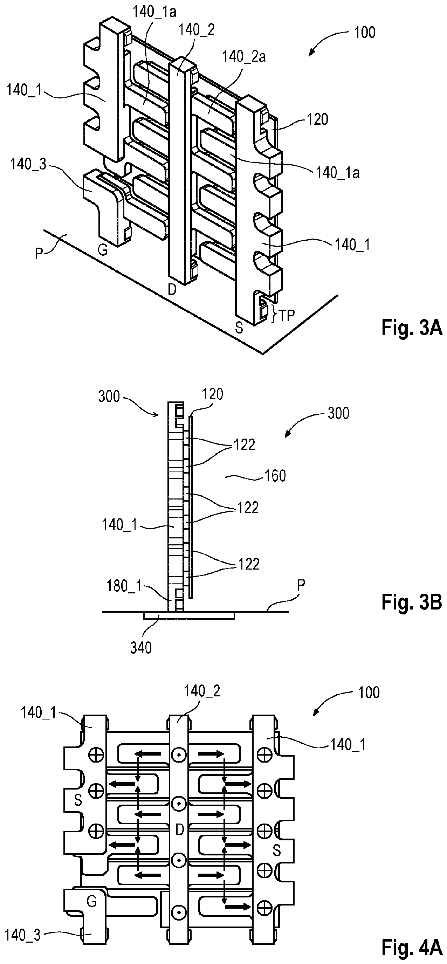

Figures 3A and 3B illustrate the GaN chip package 100 oriented inclined (here and hereinafter always shown as perpendicular without loss of generality) to a plane P of the footprint area of the (vertical) GaN chip package 100. The footprint area of the GaN chip package 100 is formed by the source terminal 180_1, the drain terminal 180_2 and the gate terminal 180_3.

The footprint area may, e.g., be formed by the end faces of the source, drain and gate segments 140_1, 140_2, 140_3, respectively. The end faces of the source, drain and gate segments 140_1, 140_2, 140_3 are side faces of the leadframe 140 which are extending between the first main side 140A and the second main side 140B of the leadframe 140, respectively.

Figure 3B illustrates a system 300 including the GaN chip package 100 attached to an application board 340 in inclined, in particular vertical orientation relative to the application board 340. It is apparent that the footprint area of the GaN chip package 100 is substantially smaller than the area of the package footprint 200 shown in Figure 2 (which is the footprint configuration of the corresponding horizontal GaN chip package). Further, Figures 3A and 3B illustrate that the footprint plane P is inclined, in particular perpendicular to a plane given by the first main side 140A or the second main side 140B of the leadframe 140 (compare Figure 1A).

Figures 4A and 4B illustrate that the load current flow is different in horizontal GaN chip packages (Figure 4A, compare also Figure 2) and vertical GaN chip packages 100, as shown in Figures 3A, 3B. The arrows illustrate the direction of load current flow. Thick arrows indicate load current flow through the leadframe 140, while thin arrows indicate load current flow through the GaN chip 120.

As apparent from a comparison of Figure 4A and Figure 4B, the "new" direction of current flow in vertical GaN chip package 100 makes the current path longer and, consequently, leads to an increase of the package resistance. To minimize this effect, the leadframe parts (source segments 140_1, drain segments 140_2, optionally gate segment 140_3) may be thicker than for the corresponding horizontal package (Figure 4A) to increase the current flow cross-section area. On the other hand, the leadframe 140 of the (vertical) GaN chip package 100 may have a more simple construction since half-etched leadframe surfaces (which are required for the horizontal package of Figure 4A) are not needed anymore.

Still referring to Figure 4B, a source bridge segment 440 may connect the first source segment 140_1 (at the right side of Figure 4B) and the second source segment 140_1 (at the left side of Figure 4B). The source bridge segment 440 may, e.g., be an integral part of the leadframe 140 or may be a separate part which is mounted to the source segments 140_1 of the leadframe 140. The source bridge segment 440 lowers the resistance of the GaN chip package 100, since at least a part of the load current may flow through the source bridge segment 440 (see thick arrows). However, it is also possible to omit the source bridge segment 440 and to rely on the current transport through the GaN chip 120.

If present, the source bridge segment 440 may be arranged at ends of the first source segment 140_1 (at the right side) and the second source segment 140_1 (at the left side) opposite the ends of the first source segment 140_1 and the second source segment 140_1 of which at least one end forms the source terminal 180_1 of the GaN chip package 100. In other words, the source bridge segment 440 may be arranged at a side of the GaN chip package 100 opposite the side at which the terminal portion TP is provided.

In the examples shown, the GaN chip package 100 includes two source segments 140_1 and one drain segment 140_2. However, it is just as possible that source and drain segments are interchanged, i.e. that the GaN chip package 100 includes a source segment 140_1 which is disposed between a first drain segment 140_2 and a second drain segment 140_2. In this case, a drain bridge segment (corresponding to the source bridge segment 440) may connect the first drain segment 140_2 and the second drain segment 140_2. Further, in this case the drain bridge segment may be arranged at ends of the first drain segment 140_2 and the second drain segment 140_2 opposite the ends of the first drain segment and the second drain segment of which at least one end forms a drain terminal 180_2 of the chip package 100.

More generally, for all examples disclosed herein, an "inverse" configuration is disclosed in which the source parts (e.g. segments, terminals, bridges, etc.) and the drain parts (e.g., segments, terminals, bridges, etc.) of the leadframe 140 are interchanged.

For example, the GaN chip package 100 may have a footprint area of a size A equal to or less than 7 mm$^2$, 6 mm$^2$, 5 mm$^2$, or 4 mm$^2$.

For example, the GaN chip package 100 may have a product $R_{on} \times A$ equal to or less than 20 $\Omega$mm$^2$, 15 $\Omega$mm$^2$, 12 $\Omega$mm$^2$, or 10 $\Omega$mm$^2$, wherein $R_{on}$ is the chip package On-resistance.

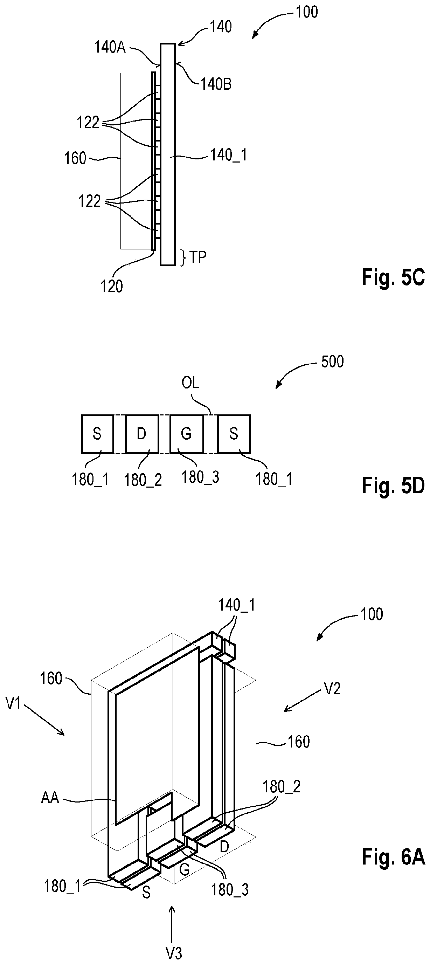

Figures 5A-12C show various examples of GaN chip packages 100 in accordance with the disclosure. All features described above with reference to GaN chip package 100 are also applicable to each of the examples described below.

Figures 5A-5D illustrate a first example of a GaN chip package 100. The GaN chip package 100 contains e.g. one GaN chip 120 (or, in general, a plurality of GaN chips 120 disposed at one main side referred to as the first main side 140A of the leadframe 140).

Here, the source bridge segment 440 is integral with the source segments 140_1, i.e. the segments 140_1 and the source bridge segment 440 are made of a single leadframe part (of, e.g., flipped U-shape). The gate segment 140_3 is arranged between the left source segment 140_1 and the drain segment 140_2. As shown in the footprint configuration 500 of Figure 5D, an order of the source, drain and gate terminals 180_1, 180_2, 180_3 is S-D-G-S. The footprint area A, defined by the outline OL, may, e.g., be A = 3 mm × 1 mm = 3 mm². That is, compared with the footprint configuration 200 of Figure 2, the footprint area A is reduced by a factor of 3 for a corresponding chip size.

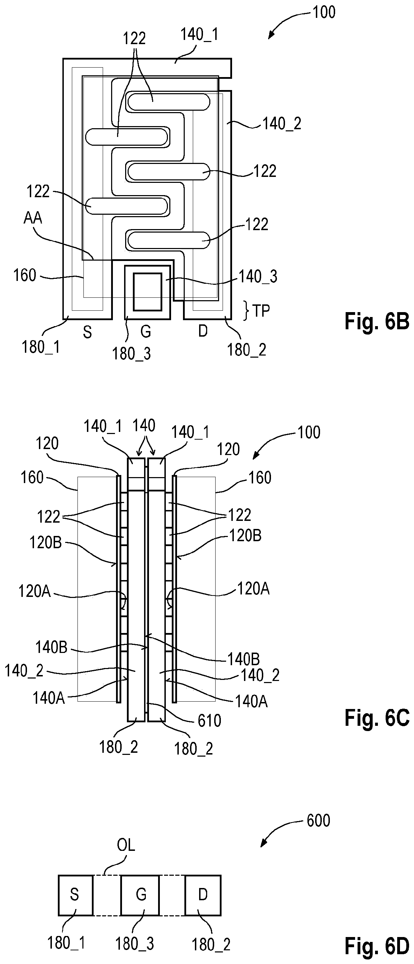

Referring to Figures 6A-6D a second example of a GaN chip package 100 may contain at least two GaN chips 120 arranged at opposite sides of the leadframe 140.

Optionally, this dual-side chip package 100 may be made by combining two single-side chip packages. For example, the GaN chip package 100 may include a further GaN chip 120 having a first side and a second side opposite the first side, wherein the first side comprises chip pads 122. The dual-side GaN chip package 100 may include a further leadframe 140. The further leadframe 140 has a first main side 140A and a second main side 140B opposite the first main side 140A. The first main side 140A of the further leadframe 140 faces the first side 120A of the further GaN chip 120 and is attached to the chip pads 122 of the further GaN chip 120. The dual-side GaN chip package 100 may then be assembled by attaching the second main side 140B of the further leadframe 140 to the second main side 140B of the leadframe 140.

For example, a bond material 610 may be used to connect the leadframe 140 and the further leadframe 140. The bond material 610 may, e.g., be an electrically conductive material such as, e.g., solder, conductive adhesive, metal paste, or diffusion solder material. In other examples, the bond material 610 may be an electrically insulating material such as, e.g., a glue material.

The dual-side GaN chip package 100 of Figures 6A-D6 may, e.g., include GaN chips 120 of smaller size (e.g. about half the size) of the GaN chip 120 used in the single-side GaN chip package 100 of Figures 5A-5D for reaching about the same $R_{on}$.

Figure 6D illustrates the footprint configuration 600 of the dual-side GaN chip package 100. For example, the order of the terminals 180_1, 180_2, 180_3 may, e.g., be S-G-D. Again, the terminals 180_1, 180_2, 180_3 may be arranged in a linear array.

The footprint area A, as defined by the outline OL of the dual-side GaN chip package 100, may be similar as the footprint area A of the single-side GaN chip package 100 (Figures 5A-5D). More specifically, the footprint area A may, e.g., be 2 mm × 1.5 mm = 3 mm².

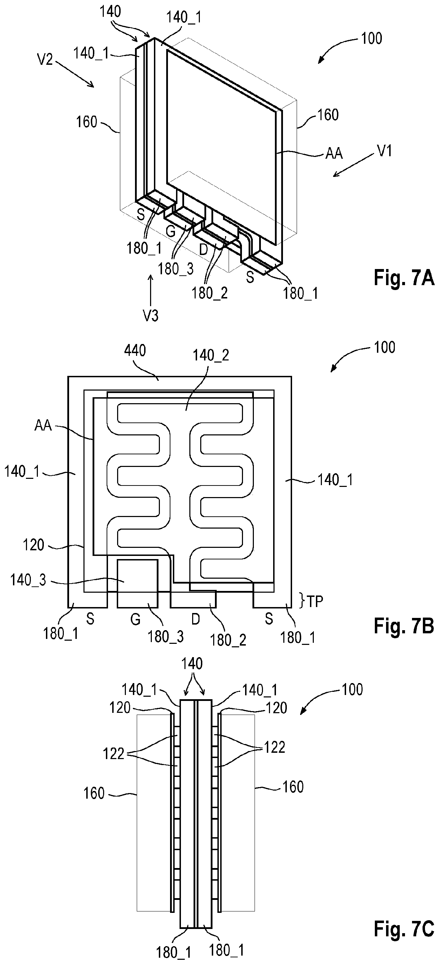

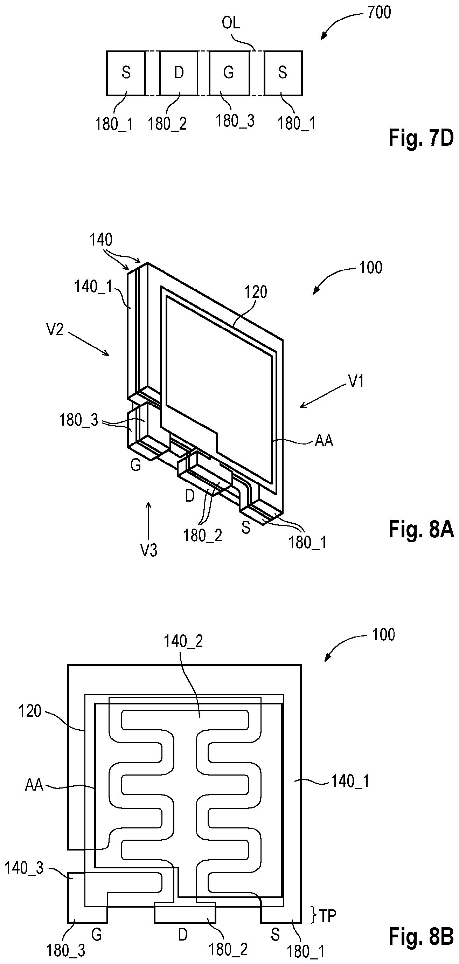

Figures 7A-7D show a third example of a GaN chip package 100. The GaN chip package 100 is a dual-side GaN chip package similar to the second example (Figures 6A-6D).

This dual-side GaN chip package 100 has two source terminals 180_1 that shorten the current path in the package 100. The footprint configuration 700 may have an order S-D-G-S. The footprint area A may, e.g., be A = 3 mm × 1.5 mm < 5 mm². Again, by virtue of the dual-side package configuration, the GaN chips 120 may have about half the size than in a single-side GaN chip package 100 (compare, e.g., the first example shown in Figures 5A-5D) of the same $R_{on}$.

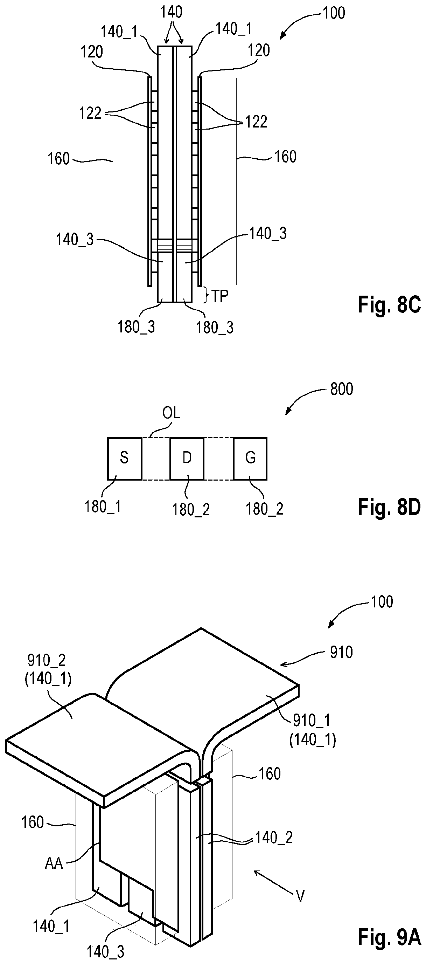

A fourth example of a GaN chip package 100 is shown in Figures 8A-8D. The GaN chip package 100 may, e.g., also be designed as a dual-side chip-package. In the fourth example the GaN chip package 100 has a "classical" footprint configuration 800 in the order of S-D-G. However, as compared to the GaN chip package 100 of the third example (Figures 7A-7D), a longer source current path increases the package resistance.

The footprint configuration 800 may define a footprint area A = 3 mm × 1.5 mm < 5 mm². That is, the footprint area may be similar than in the third example of a GaN chip package 100.

Table 1 summarizes simulation results for the GaN chip packages 100 of the first to fourth example and compares these results with the specifications of a horizontal package (Figures 1B, 2) of corresponding chip size.

Table 1 (Simulation Results)

| Package Example | $R_{on}$ (device) [mΩ] | A (footprint) [mm²] | $R_{on} \times A$ [mΩ × mm²] | Footprint configuration |
|---|---|---|---|---|
| Horizontal package | 3.05 | 9 | 27.5 | S-D-$\frac{G}{S}$ |
| First (single chip) | 3.39 | 3 | 10.5 | S-D-G-S |
| Second (dual chip) | 2.93 | 3 | 8.8 | S-G-D |
| Third (dual chip) | 1.94 | 4.5 | 8.7 | S-D-G-S |
| Fourth (dual chip) | 2.07 | 4.5 | 9.3 | S-D-G |

Table 1 reveals that the vertical GaN chip packages reveal superior values of $R_{on} \times A$ and more versatile footprint configurations. $R_{on}$ is the On-resistance of the device, i.e. the resistance of the respective GaN chip package 100.

In all examples disclosed herein, the GaN transistor chip(s) 120 may be, e.g., capable of switching high currents and/or medium voltages or high voltages (e.g., more than 50 V or 100 V or 200 V or 300 V or 400 V or 500 V blocking voltage). In particular, exemplary transistor packages 100 as disclosed herein may operate in the medium voltage (MV) range, in which the blocking voltage is equal to or greater than or less than 200 V or 150 V or 100 V or 50 V.

In all examples disclosed herein, the leadframe(s) 140 may have a thickness equal to or greater than or less than 150 $\mu$m or 200 $\mu$m or 250 $\mu$m or 500 $\mu$m or 900 $\mu$m or 1.27 mm or 2.0 mm.

The (power) transistor GaN chip(s) 120 may be, e.g., a HEMT (high electron mobility transistor) device, for example.

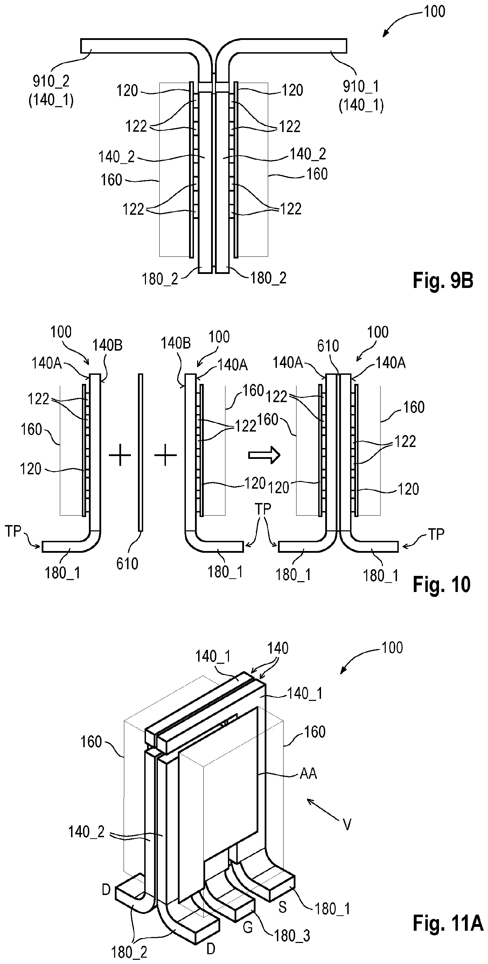

Figures 9A and 9B illustrate a GaN chip package 100 which is equipped with a heat sink 910 disposed at the top of the GaN chip package 100. The heat sink 910 may, e.g., be connected to the leadframe 140 or may be a part of the leadframe 140. In the example shown, the heat sink 910 is, e.g., a part of the source segment 140_1 of the leadframe 140. Further, as a dual-side GaN chip package 100 is shown, the heat sink 910 may, e.g. include a first heat sink 910_1 and a second heat sink 910_2. The first heat sink 910_1 may be connected to or form a part of the first leadframe 140 (e.g., of the source segment 140_1 thereof), while the second heat sink 910_2 may, e.g., be connected or form a part of the further leadframe 140 (e.g., of the source segment 140_1 thereof).

The heat sink 910 (in particular, the first and second heat sinks 910_1 and 910_2) may be formed by bent parts of the leadframe 140.

Figure 10 illustrates the concept of combining two (modified) single-side GaN chip packages 100 to obtain a dual-side GaN chip package 100.

Further, Figure 10 illustrates the general concept of designing the terminal portion TP of the leadframe 140 as parts which are bent out of the plane given by the first main side 140A or the second main side 140B of the leadframe 140. In the example shown in Figure 10, the source terminals 180_1 are the parts of the leadframe 140 which are bent out. However, alternatively or in addition, any of the drain terminal(s) 180_2 or the gate terminal(s) 180_3 may be formed by such bent-out parts.

Figures 11A-11B illustrate a GaN chip package 100 using bent parts of the leadframe 140 as package terminals. More specifically, a bent part of the source segment 140_1 is used as a source terminal 180_1, a bent part of the drain segment 140_2 is used as a drain terminal 180_2 and a bent part of the gate segment 140_3 is used as a gate terminal 180_3, for example. The concept of using bent parts of the leadframe 140 as package terminals enlarge the terminal area for mounting the GaN chip package 100 to an application board (not shown). Further, the current density at the terminal portion TP is reduced and a better stability of the GaN chip package 100 on the application board (not shown) is obtained.

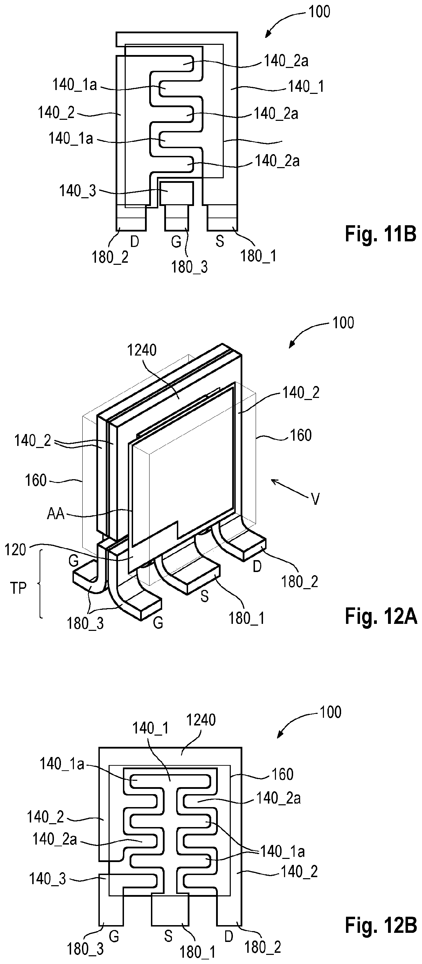

The fifth example of a GaN chip package 100 as shown in Figures 11A, 11B has a footprint configuration in which an order of the terminals in the direction of the linear array along which the terminals are arranged is D-G-S (which is identical to S-G-D).

Except the bent leadframe parts at the terminal portion TP of the leadframe 140, the fifth example of a GaN chip package 100 (Figures 11A-11B) is similar to the second example of a GaN chip package 100 as shown in Figures 6A-6D. Therefore, in order to avoid reiteration, reference is made to the above description.

Figures 12A-12C illustrate a sixth example of a GaN chip package 100. This GaN chip package 100 is also of the dual-side GaN chip type and may, e.g., also rely on the concept of using bent leadframe parts for the terminal portion TP of the package 100.

This GaN chip package 100 has a footprint configuration in which the terminals are arranged along a linear array in the order G-S-D. The source segment 140_1 is, e.g., arranged between two drain segments 140_2. The drain segments 140_2 may, e.g., be connected by a drain bridge segment 1240. Similar as described above with respect to the source bridge segment 440 (see Figures 4B, 5B), the drain bridge segment 1240 may be an integral part of the leadframe 140 or may be a separate part which has been attached to the two drain segments 140_2.

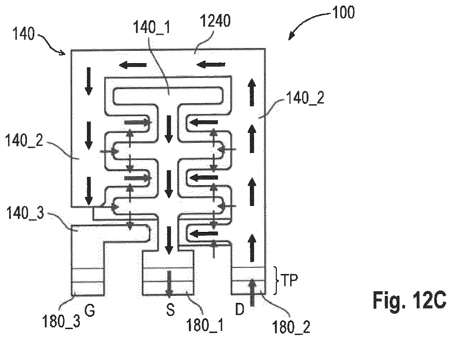

Figure 12C illustrates the current flow in the GaN chip package 100 of Figures 12A-12B. The whole chip area may be engaged. Further, the thickness of the leadframe 140 and the wideness of the load current terminals 180_1, 180_2 may be chosen as large as desired to reduce package resistance and to improve thermal properties. Other than in horizontal packages, no half-etched surfaces of the leadframe 140 are required, which reduces cost.

Generally, the vertical GaN chip package 100 design allows to reduce the footprint area and the product of footprint area and package resistance ($R_{on}$) if compared with corresponding horizontal packages. Further, the vertical package design disclosed herein enables dual-side GaN chip package options. That is, in a discrete device at least two GaN chips 120 may be mounted at both sides of the leadframe 140 (by using, e.g., two leadframes 140_1, 140_2 attached to each other). The dual-side package design enables a discrete transistor device in which two GaN chips 120 are connected in parallel.

The dual-side GaN chip package design makes it possible either to increase the total chip area (which is essential for high power applications) or to further reduce the footprint area A.

No principle changes in chip-package interface leadframe technology are required when compared with existing horizontal GaN chip packages. Rather, more simple leadframes may be used since half-etched surfaces are not required.

EXAMPLES

The following examples pertain to further aspects of the disclosure:

Example 1 is a chip package. The chip package includes a GaN chip having a first side and a second side opposite the first side. The first side comprises chip pads. The chip package further includes a leadframe having a first main side and a second main side opposite the first main side. The first main side of the leadframe faces the first side of the GaN chip and is attached to the chip pads. The leadframe is configured to be attached to an application board in inclined, in particular vertical orientation relative to the application board.

In Example 2, the subject matter of Example 1 can optionally include wherein the leadframe comprises a terminal portion which is part of a footprint area of the chip package, wherein the footprint area lies in a plane which is inclined, in particular perpendicular to a plane given by the first main side or the second main side of the leadframe.

In Example 3, the subject matter of Example 2 can optionally include wherein the terminal portion of the leadframe comprises side faces of the leadframe which are extending between the first main side and the second main side of the leadframe.

In Example 4, the subject matter of Example 2 or 3 can optionally include wherein the terminal portion of the leadframe comprises parts of the leadframe which are bent out of the plane given by the first main side or the second main side of the leadframe.

In Example 5, the subject matter of any of the preceding Examples can optionally include wherein the leadframe comprises a plurality of segments, the plurality of segments comprising: at least one source segment connected to source pads of the GaN chip, at least one drain segment connected to drain pads of the GaN chip, and at least one gate segment connected to a gate pad of the GaN chip, wherein the chip package comprises: at least one source terminal formed by an end portion of the source segment, at least one drain terminal formed by an end portion of the drain segment, and at least one gate terminal formed by an end portion of the gate segment.

In Example 6, the subject matter of Example 5 can optionally include wherein the source segment is an elongated segment having laterally protruding source arms, the drain segment is an elongated segment having laterally protruding drain arms, and the source arms and the drain arms are interdigitated.

In Example 7, the subject matter of Example 5 or 7 can optionally include wherein a drain segment is disposed between a first source segment and a second source segment, and a source bridge segment connects the first source segment and the second source segment, or a source segment is disposed between a first drain segment and a second drain segment, and a drain bridge segment connects the first drain segment and the second drain segment.

In Example 8, the subject matter of Example 7 can optionally include wherein the source bridge segment is arranged at ends of the first source segment and the second source segment opposite the ends of the first source segment and the second source segment of which at least one end forms a source terminal of the chip package, or the drain bridge segment is arranged at ends of the first drain segment and the second drain segment opposite the ends of the first drain segment and the second drain segment of which at least one end forms a drain terminal of the chip package.

In Example 9, the subject matter of any of Examples 5 to 8 can optionally include wherein the at least one source terminal and the at least one drain terminal and the at least one gate terminal of the chip package are arranged in a linear array aligned with the leadframe in vertical projection.

In Example 10, the subject matter of Example 9 can optionally further wherein an order of the at least one source terminal denoted by S, the at least one drain terminal denoted by D and the at least one gate terminal denoted by G is, in the direction of the linear array, S-D-G or S-D-G-S or S-G-D or D-S-G or S-D-G-S or D-G-S-D.

In Example 11, the subject matter of any of the preceding Examples can optionally further include a heatsink connected to or forming a part of the leadframe and disposed at the top of the chip package.

In Example 12, the subject matter of any of the preceding Examples can optionally further include a further GaN chip having a first side and a second side opposite the first side, wherein the first side comprises chip pads; and a further leadframe having a first main side and a second main side opposite the first main side, wherein the first main side of the further leadframe faces the first side of the further GaN chip and is attached to the chip pads of the further GaN chip, wherein the second main side of the further leadframe is attached to the second main side of the leadframe.

In Example 13, the subject matter of Example 12 can optionally include wherein the further leadframe is configured to be attached to the application board in vertical orientation relative to the application board.

In Example 14, the subject matter of Example 12 or 13 can optionally include wherein the second side of the further leadframe is attached to the second side of the leadframe by an electrically conductive bond material.

In Example 15, the subject matter of any of the Examples 12 to 14 can optionally further include a further heatsink connected to or forming a part of the further leadframe and disposed at the top of the chip package.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

**Claims**

1. A chip package, comprising:

    a GaN chip having a first side and a second side opposite the first side, wherein the first side comprises chip pads; and
    a leadframe having a first main side and a second main side opposite the first main side, wherein the first main side of the leadframe faces the first side of the GaN chip and is attached to the chip pads, wherein
    the leadframe is configured to be attached to an application board in inclined, in particular vertical orientation relative to the application board.

2. The chip package of claim 1, wherein the leadframe comprises a terminal portion which is part of a footprint area of the chip package, wherein the footprint area lies in a plane which is inclined, in particular perpendicular to a plane given by the first main side or the second main side of the leadframe.

3. The chip package of claim 2, wherein the terminal portion of the leadframe comprises side faces of the leadframe which are extending between the first main side and the second main side of the leadframe.

4. The chip package of claim 2 or 3, wherein the terminal portion of the leadframe comprises parts of the leadframe which are bent out of the plane given by the first main side or the second main side of the leadframe.

5. The chip package of any of the preceding claims, wherein the leadframe comprises a plurality of segments, the plurality of segments comprising:

    at least one source segment connected to source pads of the GaN chip,
    at least one drain segment connected to drain pads of the GaN chip, and
    at least one gate segment connected to a gate pad of the GaN chip, wherein the chip package comprises:

        at least one source terminal formed by an end portion of the source segment,
        at least one drain terminal formed by an end portion of the drain segment, and
        at least one gate terminal formed by an end portion of the gate segment.

6. The chip package of claim 5, wherein the source segment is an elongated segment having laterally protruding source arms, the drain segment is an elongated segment having laterally protruding drain arms, and the source arms and the drain arms are interdigitated.

7. The chip package of claim 5 or 6, wherein

    a drain segment is disposed between a first source segment and a second source segment, and a source bridge segment connects the first source segment and the second source segment, or
    a source segment is disposed between a first drain segment and a second drain segment, and a drain bridge segment connects the first drain segment and the second drain segment.

8. The chip package of claim 7, wherein

    the source bridge segment is arranged at ends of the first source segment and the second source segment opposite the ends of the first source segment and the second source segment of which at least one end forms a source terminal of the chip package, or
    the drain bridge segment is arranged at ends of the first drain segment and the second drain segment opposite the ends of the first drain segment and the second drain segment of which at least one end forms a drain terminal of the chip package.

9. The chip package of any of claims 5 to 8, wherein the at least one source terminal and the at least one drain terminal and the at least one gate terminal of the chip package are arranged in a linear array aligned with the leadframe in vertical projection.

10. The chip package of claim 9, wherein an order of the at least one source terminal denoted by S, the at least one drain terminal denoted by D and the at least one gate terminal denoted by G is, in the direction of the linear array, S-D-G or S-D-G-S or S-G-D or D-S-G or S-D-G-S or D-G-S-D.

11. The chip package of any of the preceding claims, further comprising:
a heatsink connected to or forming a part of the leadframe and disposed at the top of the chip package.

12. The chip package of any of the preceding claims, further comprising:

a further GaN chip having a first side and a second side opposite the first side, wherein the first side comprises chip pads; and
a further leadframe having a first main side and a second main side opposite the first main side, wherein the first main side of the further leadframe faces the first side of the further GaN chip and is attached to the chip pads of the further GaN chip, wherein
the second main side of the further leadframe is attached to the second main side of the leadframe.

13. The chip package of claim 12, wherein
the further leadframe is configured to be attached to the application board in vertical orientation relative to the application board.

14. The chip package of claim 12 or 13, wherein the second side of the further leadframe is attached to the second side of the leadframe by an electrically conductive bond material.

15. The chip package of any of claims 12 to 14, further comprising:
a further heatsink connected to or forming a part of the further leadframe and disposed at the top of the chip package.

Fig. 1A

Fig. 1B

Fig. 2

EP 4 607 589 A1

Fig. 3A

Fig. 3B

Fig. 4A

12

Fig. 4B

Fig. 5A

Fig. 5B

**Fig. 5C**

**Fig. 5D**

**Fig. 6A**

100

122    140_1

140_2

122

122

122

AA

160    140_3

} TP

S    G    D

180_1    180_3    180_2

**Fig. 6B**

140_1  140  140_1

120    120

160    160

122    122

120B    120B

120A    120A

140B    140B

140_2    140_2

140A    140A

610

180_2    180_2

**Fig. 6C**

600

OL

| S | G | D |

180_1    180_3    180_2

**Fig. 6D**

**Fig. 7A**

**Fig. 7B**

**Fig. 7C**

OL

700

| S | D | G | S |

180_1  180_2  180_3  180_1

**Fig. 7D**

140
140_1
V2
120
100
180_3
G
V1
D
S
AA
180_2  180_1
V3

**Fig. 8A**

140_2
100
120
AA
140_3
140_1
180_3  G
D  S
180_2  180_1
}TP

**Fig. 8B**

Fig. 8C

Fig. 8D

Fig. 9A

**Fig. 9B**

**Fig. 10**

**Fig. 11A**

Fig. 11B

Fig. 12A

Fig. 12B

Fig. 12C

Europäisches
Patentamt

European
Patent Office

Office européen
des brevets

## EUROPEAN SEARCH REPORT

**Application Number**

EP 24 15 8949

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/353766 A1 (TAN TIAN SAN [MY] ET AL) 4 December 2014 (2014-12-04) * paragraphs [0003] - [0008], [0022] - [0026], [0032]; figures 1-2b,5a-5c, 9A-10B * | 1-15 | INV. H01L23/495 |

| | | | TECHNICAL FIELDS SEARCHED (IPC) |
|---|---|---|---|
| | | | H01L |

The present search report has been drawn up for all claims

| Place of search | Date of completion of the search | Examiner |
|---|---|---|
| The Hague | 9 July 2024 | Rutsch, Gerald |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 8949

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2024

| Patent document cited in search report | Publication date | Patent family member(s) | Publication date |
|---|---|---|---|
| US 2014353766 A1 | 04-12-2014 | CN 104218007 A <br> DE 102014107088 A1 <br> US 2014353766 A1 | 17-12-2014 <br> 04-12-2014 <br> 04-12-2014 |